Europäisches Patentamt

European Patent Office

Office européen des brevets

(11) Publication number: **0 195 159**
**B1**

(12) **EUROPEAN PATENT SPECIFICATION**

(45) Date of publication of patent specification: **02.01.91**

(51) Int. Cl.⁵: **G 06 K 19/06, H 01 R 23/70**

(21) Application number: **85306897.1**

(22) Date of filing: **27.09.85**

(54) Semiconductor integrated circuit card.

(30) Priority: **16.03.85 JP 37898/85**

(43) Date of publication of application:
**24.09.86 Bulletin 86/39**

(45) Publication of the grant of the patent:
**02.01.91 Bulletin 91/01**

(84) Designated Contracting States:
**DE FR GB**

(56) References cited:
**EP-A-0 134 110**
**DE-A-2 016 485**
**US-A-2 868 166**
**US-A-3 861 775**
**US-A-4 095 866**

(73) Proprietor: **MIPS CO., LTD.**
**3-B18, Nakase 1-chome**
**Chiba-shi Chiba-ken (JP)**

(72) Inventor: **Hamada, Yoshitaka**
**13, 2-ban, 6-chome, Ikuta Tama-ku**
**Kawasaki-shi Kanagawa-ken (JP)**

(74) Representative: **Brunner, Michael John et al**
**GILL JENNINGS & EVERY 53-64 Chancery Lane**
**London WC2A 1HN (GB)**

Courier Press, Leamington Spa, England.

## Description

This invention relates to semiconductor integrated circuit cards (IC cards). These usually consist (see Figures (2(a) and 2(b)) of a compact, thin, inflexible card body 1 usually measuring about 85.6 mm long 54 mm wide, and 0.8—2.0 mm thick, in which an IC chip 2 (integrated circuit element) having desired functions is built into a rigid or semi-rigid card body made of plastic or reinforced cardboard. A plurality of circuit terminals 3 are arranged along the edge on the surface of the card.

On the card A of this prior art example, an IC chip 2 is built into the card by inserting a printed circuit board 5, carrying the IC chip 2, into a rectangular hollow 4 in the surface of the card body 1 positioned near the lower edge of the card, with the chip side towards the hollow 4, and by fixing the circuit board 5 in place with adhesive. Printed conductor wires 6 connect the chip 2 to terminals 3 which are metal printed terminals along the lower board edge corresponding to the lower card edge, on the board surface opposite the IC chip mounting surface and connected to the corresponding printed wires 6 through holes.

When the card A is inserted into a card slot in a piece of electronic equipment (not shown) such as a personal computer, hand-held computer, or a TV game machine, with the card edge having the terminals 3 in the direction of insertion, the terminals 3 on the card and the corresponding terminals on the connectors of the electronic equipment into which the card is inserted come into contact with each other to conduct, that is, the IC chip 2 on the card is connected to the circuitry in the electronic equipment so that information may be transferred between them.

The number of terminals arranged along the card edge on the card surface may vary depending on the function of the built-in IC chip. When a large number of terminals is desired, the required number of terminals 3 must be closely arranged by reducing the intervals $\alpha$ between terminals or reducing the width $\beta$ of individual terminals, since the standard card width is virtually fixed at about 54 mm as mentioned above.

Reduction of a $\alpha$ or $\beta$, however, may cause problems of electromagnetic interference, short circuits between terminals due to minute particles of dirt and dust, misalignment between the terminals on the card and the terminals on the electronic equipment due to deviation of card insertion position, and so forth.

Therefore, the reduction of $\alpha$ and $\beta$ in order to increase the required number of terminals (by closer arrangement of the terminals) has limits.

DE—A—2 016 485 and EP—A—0 134 110 disclose IC cards with plural rows of terminals, in the first case the terminals being on opposite sides of the card and in the second case on the same side of the card.

US—A—3 868 166 teaches the use of offset rows of contact pins in an edge connector for a printed circuit board, but does not suggest the application of this principle to the board contacts.

An object of the invention is to allow an IC card to contain a large number of terminals without incurring the problems mentioned above.

This is accomplished according to the invention by arranging two or more transverse rows of circuit terminals along the edge of the card surface and by staggering the terminals of one row with respect to those of an adjacent row.

When the circuit terminals are arranged in this way, the total required number of terminals can be accommodated by increasing the rows of terminals, while the desirable dimensions of the terminal spacing and the individual terminal width can be kept the same so that the foregoing problems are avoided.

In the drawings:—

Figure 1 is an enlarged plan view of the major portion of an example according to the invention;

Figures 2(a) and 2(b) are a plan view and an enlarged vertical view of the major part, respectively, of an example of a conventional IC card; and

Figure 3 is a vertical sectional view of a card and a card case.

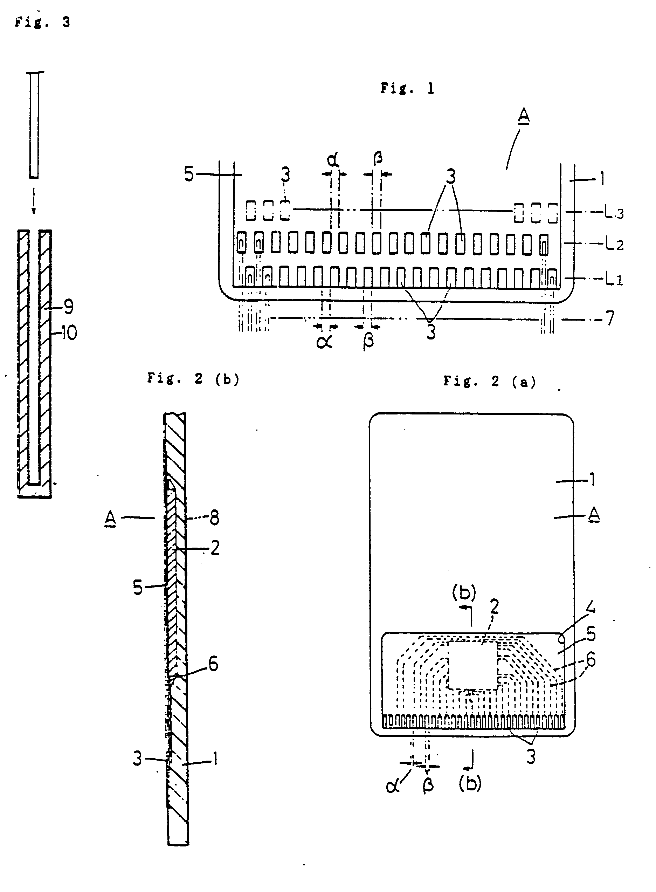

Figure 1 illustrates an enlarged plan view of an IC card A on which a total of 38 circuit terminals are arranged in two rows, each row having 19 terminals, and the terminals in the two rows L1 and L2 being arranged in a staggered formation.

The intervals between terminals in the terminal rows L1 and L2 and the width of an individual terminal can be set easily in such a manner as to avoid any problems, since the number of terminals in each row is relatively small.

An increase of terminals rows to three rows (L3 indicated in faint lines) or more can accommodate a larger number of terminals without posing any problems.

In addition, such rows of terminals can be arranged on both surfaces on the card to accommodate an even larger number of terminals.

A series of corresponding terminals 7 on the electronic equipment make contact with the rows of terminals 3 on the card A when the card is inserted into the electronic equipment.

The card body 1 of the card A protects the built-in IC chip 2 from static electricity developed by friction. In order to prevent incoming electromagnetic wave noise from entering the card circuitry (to shield the card circuitry), a conductive film 8 (Figure 2(b)), which may be an electroplated film, metal film, or other conductive coating should be applied on areas other than the terminal arrangement area on the card A or on a required part of that area.

Figure 3 shows a protective case for storing the card A. The case is made of conductive material to protect the built-in chip 2 on the stored card A from static electricity. In another alternative, the entire inner and outer surfaces or a required part of the surfaces of the case may be covered with a conductive film 10.

## Claims

1. An IC card, having an plurality of circuit terminals (3) arranged in two or more transverse rows (L) at an edge of a surface of the card, characterised in that the circuit terminals (3) in the rows (L) are arranged in a staggered formation offset from one another.

2. An IC card according to claim 1, wherein there are two rows of circuit terminals.

3. An IC card according to claim 1, wherein there are three rows of circuit terminals.

4. An IC card according to any of claims 1 to 3, wherein rows (L) of circuit terminals are positioned on both faces of the card.

## Patentansprüche

1. Eine IC-Karte, mit einer Mehrzahl von Schaltungsanschlüssen (3), die in zwei oder mehreren transversalen Reihen (L) am Rand einer Oberfläche der Karte angeordnet sind, dadurch gekennzeichnet, daß die Schaltungsangschlüsse (3) in den Reihen (L) in versetzter, zueinander verspringender Formation angeordnet sind.

2. Eine I-Karte nach Anspruch 1, wobei zwei Reihen Schaltungsanschlüsse vorgesehen sind.

3. Eine IC-Karte nach Anspruch 1, wobei drei Reihen Schaltungsanschlüsse vorgesehen sind.

4. Eine IC-Karte nach einem der Ansprüche 1 bis 3, wobei Reihen (L) der Schaltungsanschlüsse auf beiden Flächen der Karte angeordnet sind.

## Revendications

1. Carte à circuit intégré, possédant plusieurs bornes de circuit (3) disposées suivant deux rangées transversales, ou plus, (L) en un bord d'une surface de la carte, caractérisée en ce que les bornes de circuit (3) se trouvant sur les rangées (L) sont disposées de manière mutuellement décalée.

2. Carte à circuit intégré selon la revendication 1, où il existe deux rangées de bornes de circuit.

3. Carte à circuit intégré selon la revendication 1, où il existe trois rangées de bornes de circuit.

4. Carte à circuit intégré selon l'une quelconque des revendications 1 à 3, où des rangées (L) de bornes de circuit sont disposées sur les deux faces de la carte.

Fig. 3

Fig. 1

Fig. 2 (b)

Fig. 2 (a)